(19) Europäisches Patentamt / European Patent Office / Office européen des brevets

(11) **EP 1 593 982 B1**

(12) **FASCICULE DE BREVET EUROPEEN**

(45) Date de publication et mention
de la délivrance du brevet:
**28.09.2016 Bulletin 2016/39**

(51) Int Cl.:
***G06F 17/50*** *(2006.01)*

(21) Numéro de dépôt: **05290913.2**

(22) Date de dépôt: **26.04.2005**

(54) **Contrôle de la robustesse d'une modélisation d'un système physique**

Prüfung der Robustheit einer Modellierung eines physikalischen Systems

Test of the robustness of a modeling of a physical system

(84) Etats contractants désignés:
**BE DE ES FR GB IT**

(30) Priorité: **05.05.2004 FR 0404805**

(43) Date de publication de la demande:
**09.11.2005 Bulletin 2005/45**

(73) Titulaire: **SNECMA
75015 Paris (FR)**

(72) Inventeurs:
• **Granier, Hugues
77210 Samoreau (FR)**
• **Bregaint, Christian
77176 Nandy (FR)**
• **Tonnelier, Philippe
77000 Livry sur Seine (FR)**
• **Croix, Marie Marc
91830 Auvernaux (FR)**

(74) Mandataire: **Delumeau, François Guy et al
Cabinet Beau de Loménie
158, rue de l'Université
75340 Paris Cedex 07 (FR)**

(56) Documents cités:
**EP-A- 1 117 044     GB-A- 2 362 728
US-B1- 6 577 981**

• **CHAKRABARTY S. ET AL: "A virtual test-bench
for analog circuit testability analysis and fault
diagnosis", AUTOTESTCON '98. IEEE SYSTEMS
READINESS TECHNOLOGY CONFERENCE, 24
August 1998 (1998-08-24), pages 337-352,
XP010299412, NEW YORK, NY, USA, IEEE, US**

**Description**

Domaine de l'invention

La présente invention se rapporte au domaine de contrôle de la robustesse d'une modélisation d'un système physique par rapport à l'apparition de pannes.

Art antérieur

Dans de nombreuses industries, telles que l'aéronautique ou le spatial, on fait couramment appel à des modélisations des systèmes. Par exemple, on conçoit un modèle d'un système physique destiné à accomplir une mission donnée, pour évaluer les interférences entre le système et son environnement. Pour cela, on utilise des moyens matériels ou logiciels.

En particulier, des logiques de détection de pannes, de re-configuration et des redondances des composants sont utilisés pour rendre le système tolérant aux pannes.

Le document intitulé « A virtual test-bench for analog circuit testability analysis and fault » de Chakrabarty et al. (AUTOTESTCON 98, IEEE Systems Readiness Technology Conference, 1998 Salt Lake City, USA) décrit une méthode pour détecter et diagnostiquer des erreurs dans un circuit analogique.

Or, il est presque impossible que le modèle prenne en compte toutes les possibilités. Il arrive souvent qu'on oublie un scénario particulier, ou qu'on fait une erreur de logique séquentielle, de sorte qu'une séquence ou une combinaison particulière de pannes peut mettre le système en défaut.

Afin de résoudre ces problèmes, des tests au banc système sont réalisés sur le vrai système afin de vérifier sa robustesse. Mais lors de la découverte d'un défaut du système réel, il faut re-concevoir ce système impliquant ainsi des grands coûts de ré-ingénierie, de retro-conception matérielles et logicielles ainsi qu'une importante perte de temps.

Objet et résumé de l'invention

La présente invention a donc pour objet de résoudre les problèmes précités en proposant une méthode de contrôle de la robustesse d'une modélisation d'un système électronique par rapport aux pannes.

A cet effet, elle propose une méthode de contrôle de la robustesse d'une modélisation d'un système électronique comportant un premier et un second calculateur (112a, 112b) pour contrôler un moteur d'avion, ledit procédé comporte les étapes suivantes :- définition d'un premier modèle (10) du système électronique modélisant ledit premier et second calculateur (112a, 112b) et un harnais (112c) intercalculateur comportant des fils de liaison permettant l'échange de données entre ledit premier et second calculateur (112a, 112b), ledit premier modèle (10) comportant un ensemble (12) de composants (12a, 12b, 12c) et au moins une interface d'entrée (14) destinée à l'introduction de valeurs d'entrées, ledit premier modèle étant défini dans un langage formel décrivant le comportement et la fonction de chacun desdits composants ;- définition dans le langage formel d'une propriété déterminée qui doit être satisfaite par la modélisation du système électronique ;- recherche automatique par un moyen de preuve formelle d'une combinaison de valeurs d'entrées qui met en défaut ladite propriété déterminée vis-à-vis du premier modèle pour vérifier la véracité de ladite propriété déterminée;- définition dans le langage formel d'un second modèle (20) correspondant au premier modèle enrichi par un mécanisme d'injection de pannes (22) lorsque ladite propriété déterminée est vérifiée comme étant vraie pour le premier modèle;- recherche automatique par un moyen de preuve formelle d'une combinaison d'injection de pannes et/ou de valeurs d'entrées qui met en défaut ladite propriété déterminée vis-à-vis du second modèle, ladite propriété déterminée étant considérée comme vraie par rapport au second modèle (20) lorsque le moyen de preuve formelle ne trouve aucune combinaison d'injection de pannes et/ou de valeurs d'entrées qui met en défaut ladite propriété déterminée; et- considérer la modélisation du système électronique comme robuste par rapport aux pannes vis-à-vis de ladite propriété déterminée lorsque ladite propriété déterminée est vérifiée comme étant vraie pour le second modèle.

Cette méthode permet de vérifier les propriétés du système en prenant en compte, différentes combinaisons de pannes et/ou de valeurs d'entrées du système.

Elle permet aussi la réalisation d'un système de très grande qualité et d'une sécurité optimale, grâce à une vérification exhaustive de toute panne ou séquence de pannes envisageables.

Selon une particularité de l'invention, le mécanisme d'injection de pannes comporte l'injection d'au moins une panne dans le second modèle à travers une interface d'entrée de pannes.

Selon une autre particularité de l'invention, le mécanisme d'injection de pannes comporte en outre la description dans le langage formel du ou des effets de ladite au moins une panne sur la fonction ou le comportement de chacun des composants dudit système électronique.

La propriété déterminée est considérée comme vraie par rapport au second modèle lorsque le moyen de preuve formelle ne trouve aucune combinaison d'injection de pannes et/ou de valeurs d'entrées qui met en défaut ladite propriété déterminée. Dans ce cas, la modélisation du système physique est considérée comme robuste par rapport à ladite propriété déterminée.

La propriété déterminée est considérée comme fausse par rapport au second modèle lorsque le moyen de preuve formel trouve au moins une combinaison d'injection de pannes et/ou de valeurs d'entrées qui met en défaut ladite propriété déterminée. Dans ce cas, la combinaison d'injection de pannes et/ou de valeurs d'entrées mettant en défaut la propriété déterminée correspond à un scénario permettant de corriger la modélisation du système physique pour le rendre plus robuste.

Avantageusement, la combinaison de pannes est choisie parmi un ensemble de pannes prédéfinies.

La propriété déterminée exprime un état ou un comportement dudit système physique. Elle peut être une propriété de sûreté dudit système physique.

Brève description des dessins

D'autres particularités et avantages du dispositif et du procédé selon l'invention ressortiront mieux à la lecture de la description faite ci-après, à titre indicatif mais non limitatif, en référence aux dessins annexés sur lesquels :

- la figure 1 est une vue en perspective des moyens matériels mis en oeuvre dans le système ou procédé de l'invention ;
- la figure 2 illustre très schématiquement un premier modèle pour la conception d'un système physique selon l'invention ;
- la figure 3 est un organigramme illustrant les étapes principales pour déterminer la validité du premier modèle de la figure 2 ;
- la figure 4 illustre très schématiquement un second modèle correspondant au premier modèle du système physique enrichi par un mécanisme d'injection de pannes selon l'invention ;
- la figure 5 est un organigramme illustrant les étapes principales pour contrôler la robustesse d'une modélisation du système physique par rapport à l'apparition de pannes selon l'invention ;
- la figure 6 illustre très schématiquement un exemple d'un premier modèle d'un système électronique modélisant un premier calculateur, un second calculateur, et un harnais selon l'invention ;
- la figure 7 illustre très schématiquement un second modèle correspondant au premier modèle de la figure 6 enrichi par un mécanisme d'injection de pannes ; et
- la figure 8 illustre très schématiquement le mécanisme d'injection de pannes de la figure 7.

Description détaillée de modes de réalisation

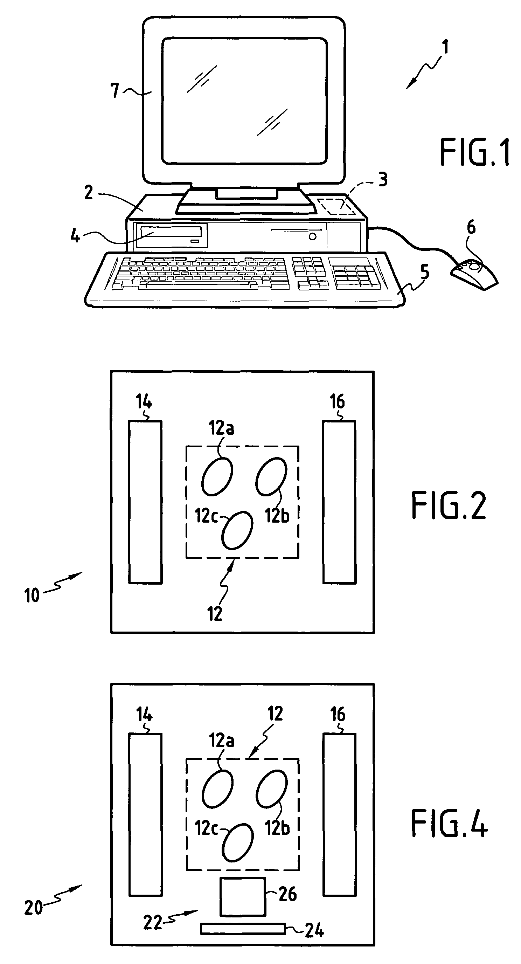

La figure 1 représente un système qui peut être utilisé pour la modélisation d'un système physique. Ce système comprend une station de travail ou ordinateur 1, utilisé pour l'exécution d'un programme informatique conçu pour mettre en oeuvre le procédé selon l'invention.

L'ordinateur 1 comprend les moyens matériels que l'on trouve habituellement avec ce type d'appareil. Plus particulièrement, l'ordinateur comprend une unité centrale 2 qui exécute les séquences d'instructions du programme selon la méthode de l'invention, une mémoire centrale 3 qui stocke les données et programmes en cours d'exécution, des supports de stockages de données numériques (disque dur, CD 4, disquette,...) conservant durablement les données et les programmes manipulés, des périphériques d'entrée (clavier 5, souris 6, ...) ainsi que des périphériques de sortie (écran 7, imprimante,...) pour pouvoir visualiser la modélisation du système physique.

Conformément à l'invention, la figure 2 illustre un premier modèle 10 pour la conception d'un système physique. Le système physique peut par exemple être un système électronique chargé de supporter, après sa réalisation, une application donnée qui peut être le contrôle ou la commande des équipements de régulation d'un moteur.

Le premier modèle 10 comporte un ensemble 12 de composants 12a, 12b, 12c qui communiquent entre eux, au moins une interface d'entrée 14 destinée à l'introduction de valeurs d'entrées, et au moins une interface de sortie 16. Bien entendu, l'ensemble 12 de composants peut être définit selon une échelle ou niveau d'abstraction en fonction de la précision ou la spécificité et la modélisation du système physique.

Ce premier modèle 10 est un modèle numérique représentant l'architecture du système physique à réaliser. Il est définit dans un langage formel comportant un alphabet ou variables, des quantificateurs logiques, et des connecteurs logiques, du type « Signal », décrivant ainsi le comportement et la fonction de chacun de ses composants 12a, 12b, 12c. Le premier modèle 10 permet alors de réaliser une représentation dynamique du système physique.

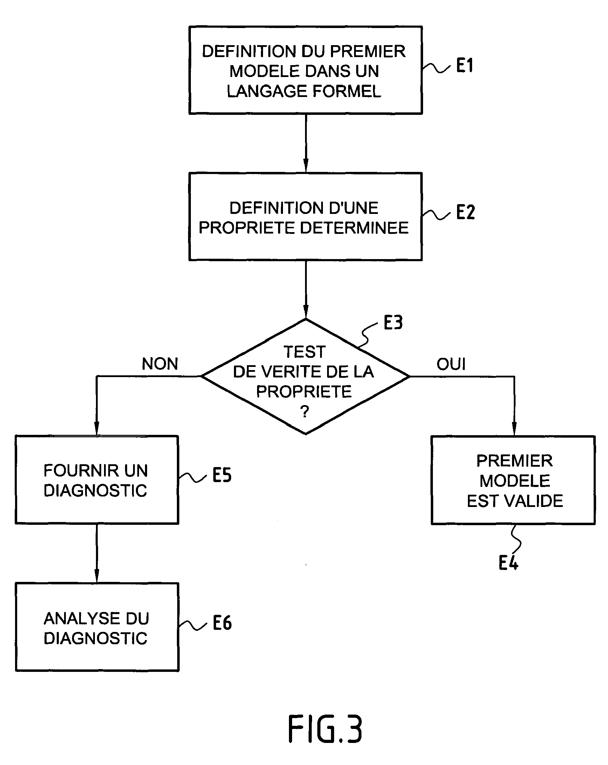

La figure 3 est un organigramme illustrant les étapes principales pour déterminer la validité du premier modèle 10.

A l'étape E1, le premier modèle est définit dans un langage formel.

Ensuite à l'étape E2, une propriété déterminée qui doit être satisfaite par la modélisation du système physique est aussi définit dans le langage formel. L'écriture formelle de la propriété consiste à définir l'événement qui correspond à cette propriété et à coder, par exemple, en langage signal cet évènement à partir des variables ou signaux du modèle. La propriété déterminée est en général une propriété de sûreté du type « tel évènement n'arrivera jamais », mais qui peut aussi être une propriété de vivacité du type « depuis tel état, il est possible d'arriver à tel autre état au bout d'un temps fini ». Cette propriété doit alors satisfaire ou décrire une caractéristique du premier modèle.

Le langage formel dispose d'un moyen de preuve formelle, tel le « prouveur formel » ou « checker » du logiciel SILDEX™, pour vérifier sémantiquement la véracité de la propriété déterminée par rapport à toute valeur ou combinaison de valeurs d'entrées introduites dans le premier modèle.

Ainsi, l'étape E3, est un test de vérité de la propriété déterminée par rapport à toute combinaison de valeurs d'entrées. En effet, à cette étape, on procède à une recherche automatique par le moyen de preuve formelle d'une combinaison de valeurs d'entrées qui met en défaut cette propriété déterminée.

Si le moyen de preuve formelle ne trouve aucune combinaison de valeurs d'entrées qui met en défaut la propriété déterminée, alors à l'étape E4, le premier modèle 10 est considérée comme valide par rapport à cette propriété.

En revanche, si la propriété déterminée est considérée comme fausse, c'est-à-dire si le moyen de preuve formelle à l'étape E3 trouve au moins une combinaison de valeurs d'entrées qui met en défaut cette propriété déterminée, alors on passe à l'étape E5.

A l'étape E5, on fournit un diagnostic comportant la séquences des valeurs d'entrées qui a mis en défaut la propriété déterminée.

A l'étape E6, selon le diagnostic fourni à l'étape précédente, le premier modèle 10 est ou bien corrigé pour que la propriété déterminée soit satisfaite, ou bien il est affirmé que la combinaison de valeurs d'entrées trouvée par le moyen de preuve formelle est très improbable.

Conformément à l'invention, la figure 4 illustre très schématiquement un second modèle 20 numérique correspondant au premier modèle 10 du système physique enrichi par un mécanisme d'injection de pannes 22.

En effet, le second modèle 20 se distingue du premier modèle 10 en ce qu'il comporte, en plus de l'ensemble 12 de composants 12a, 12b, 12c et des interfaces d'entrée 14 et de sortie 16, un mécanisme d'injection de pannes 22 comportant une interface d'entrée de pannes 24 à travers laquelle au moins une panne ou une combinaison de pannes est injectée et un moyen de mise en panne 26.

La panne ou la combinaison de pannes est choisie parmi un ensemble de pannes prédéfinies. L'effet de chaque panne sur le comportement du second modèle 20 est modélisé dans un langage formel et la conséquence d'une panne sur un composant donné est décrite dans un diagramme de comportement de ce composant. En effet, toutes les pannes possibles connues sur le moindre composant du second modèle 20 sont listées et placées ainsi que le diagramme de comportement de chaque composant dans une base de données stockée par exemple dans la mémoire centrale 3 de la station de travail ou ordinateur 1.

Autrement dit, le mécanisme d'injection de pannes 22 comporte la description dans un langage formel du ou des effets de toute panne sur la fonction ou le comportement de chacun des composants 12a, 12b, 12c du second modèle 20 modélisant le système physique.

Ainsi, le second modèle 20 correspond au premier modèle 10 augmenté d'autant d'entrées booléennes supplémentaires et des traitements associés aux pannes prévues. L'entrée d'une panne peut alors prendre une des deux valeurs « faux » ou « vrai ». Par exemple, la valeur « faux » peut correspondre à l'état « pas d'injection de panne » et la valeur « vrai » correspond à l'état « injection de panne ».

Lorsque toutes les entrées de l'interface d'entrée de pannes 24 sont à faux, alors le second modèle 20 est en fonctionnement nominal. Lorsqu'une entrée de panne est à vrai, elle va déclencher la logique de mise en panne du composant concerné selon le diagramme de comportement de ce composant.

En outre, lorsqu'une entrée de panne est libre, alors le moyen de preuve formelle peut introduire une panne à tout instant dans le but de chercher une séquence ou combinaison de pannes et/ou de valeurs d'entrées qui puisse mettre en défaut la propriété déterminée.

Le moyen de preuve formelle est un outil qui applique des règles logiques à des axiomes et/ou aux diagrammes de comportements des composants 12a, 12b, 12c du second modèle 20 jusqu'à ce qu'il obtienne une formule décrivant la propriété déterminée.

Cet outil de preuve formelle peut être pourvu par un logiciel du type SILDEX™ qui à tout instant d'une simulation, peut mettre en panne un composant ou une fonction du second modèle 20 par l'intermédiaire du mécanisme d'injection de pannes 22.

Concrètement, pour prouver une propriété déterminée du second modèle 20, une compilation dynamique en langage formel du type SILDEX™ est lancée. Si la compilation réussit, la propriété déterminée est validée. Si non, le moyen de preuve formelle indique un scénario comportant une séquence de pannes et/ou de valeurs d'entrées qui amène la modélisation du système dans un état qui contredit cette propriété.

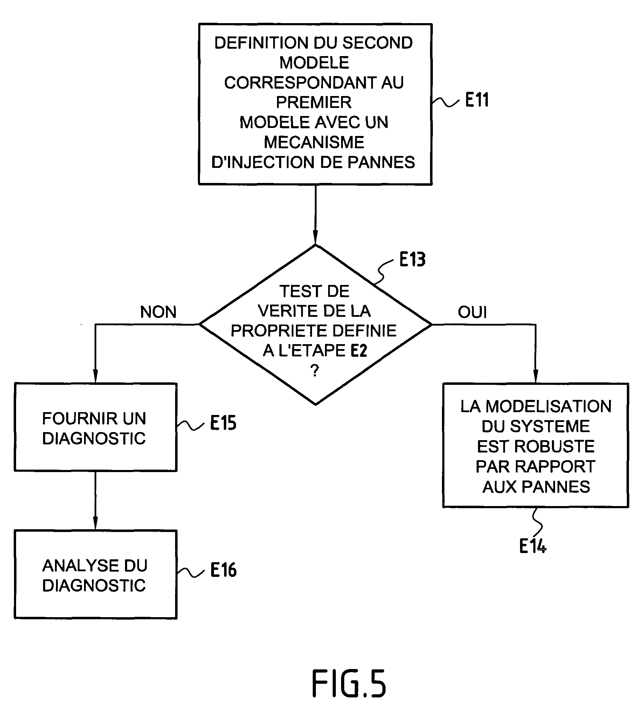

La figure 5 est un organigramme illustrant les étapes principales pour contrôler la robustesse d'une modélisation du système physique par rapport à l'apparition de pannes.

A l'étape E11, on définit dans un langage formel, le second modèle 20 correspondant au premier modèle 10 enrichi par le mécanisme d'injection de pannes 22.

Ensuite, il s'agit de vérifier si la propriété déterminée définit à l'étape E2 de l'organigramme de la figure 2 et qui a déjà été vérifiée comme étant vraie pour le premier modèle 10 (étape E4) est toujours vrai vis-à-vis du second modèle 20.

Alors à l'étape E13, la vérité de la propriété déterminée est testée par rapport à toute combinaison d'injection de pannes et/ou de valeurs d'entrées. En effet, à cette étape, on procède à une recherche automatique par le moyen de preuve formelle d'une combinaison d'injection de pannes et/ou de valeurs d'entrées qui met en défaut cette propriété déterminée.

Si le moyen de preuve formelle ne trouve aucune combinaison d'injection de pannes et/ou de valeurs d'entrées qui met en défaut cette propriété déterminée, alors la propriété est considérée comme vrai et par conséquent à l'étape E14, la modélisation du système physique est considérée comme robuste par rapport aux pannes vis-à-vis de la propriété déterminée.

En revanche, si le moyen de preuve formelle à l'étape E13 trouve au moins une combinaison d'injection de pannes et/ou de valeurs d'entrées qui met en défaut cette propriété déterminée, alors cette propriété est considérée comme fausse et par conséquent à l'étape E15, un diagnostic est fourni par le moyen de preuve formelle. Ce diagnostic comprend le scénario ou la séquence des entrées à travers les interfaces d'entrées 14, 24 de pannes et de valeurs d'entrées qui amène à la situation non désirée.

A l'étape E16, le diagnostique est analysé, c'est-à-dire on examine la séquence des opérations sur le second modèle 20 et à quels instants le ou les pannes ont été injectées. Cette analyse permet de reprendre la conception de la modélisation du système physique ou au contraire d'affirmer que le scénario trouvé, par le moyen de preuve formelle, est improbable.

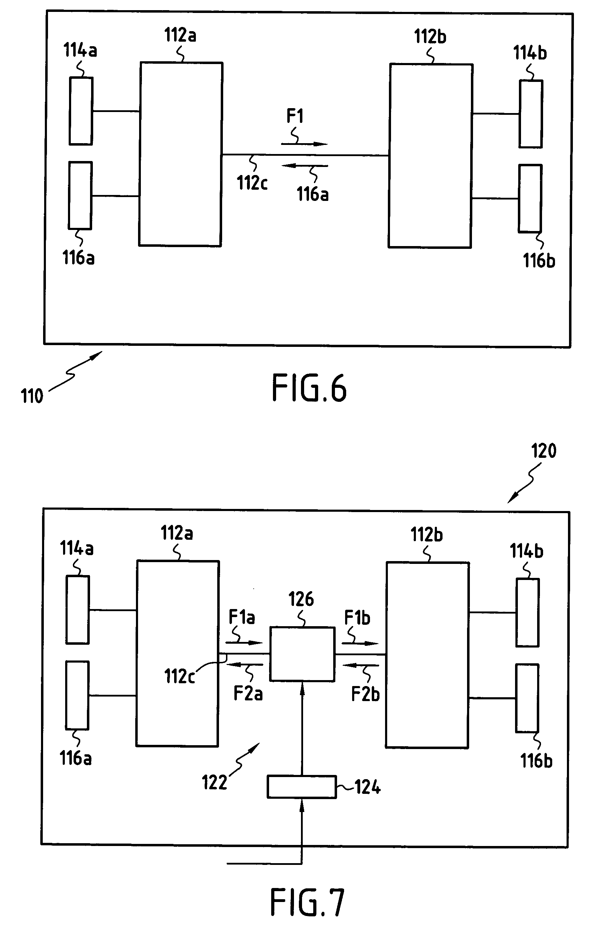

Les figures 6 à 8 illustrent un exemple simplifié de contrôle de la robustesse d'une modélisation d'un système physique.

Selon cet exemple, le système physique à concevoir est un système électronique comportant deux calculateurs pour contrôler un moteur d'avion. En fonctionnement normal, un seul calculateur contrôle le moteur et un dialogue ou échange de données existe entre les deux calculateurs. Ainsi, dans le cas où un calculateur tomberait en panne, le second calculateur doit démarrer en monocalculateur. Dans cet exemple, une perte du système est traduite par les deux calculateurs simultanément en panne ou passifs ou actifs.

Ainsi, la figure 6 illustre un exemple d'un premier modèle 110 du système physique modélisant un premier calculateur 112a comportant une première interface d'entrée 114a et une première interface de sortie 116a, un second calculateur 112b comportant une seconde interface d'entrée 114b et une seconde interface de sortie 116b, et un harnais 112c intercalculateur comportant des fils de liaison permettant le dialogue ou l'échange de données entre les premier et second calculateurs 112a, 112b. La flèche F1 désigne les signaux ou données (notés S_1_2 en langage signal) transmis par le premier calculateur 112a vers le second calculateur 112b, et la flèche F2 désigne les signaux ou données notés (S_2_1 en langage signal) allant du second calculateur 112b vers le premier calculateur 112a.

La figure 7 illustre un second modèle 120 du système physique correspondant au premier modèle 110 de la figure 6, enrichi par un mécanisme d'injection de pannes 122 comportant une interface d'entrée de panne 124 et un moyen de mise en panne 126. Selon cet exemple, le moyen de mise en panne 124 est un moyen de coupure simulant la panne simple d'un fil de liaison coupé ou des fils en court-circuit ou que le harnais 112c est non connecté. La flèche F1a désigne les signaux S_1_2 sortant du premier calculateur 112a et la flèche F1b désigne les signaux S_2_1_v entrant dans le second calculateur 112b après passage dans le moyen de mise en panne 126. La flèche F2b désigne les signaux S_2_1 sortant du second calculateur 112b et la flèche F2a désigne les signaux S_1_2_v entrant dans le premier calculateur 112a après passage dans le moyen de mise en panne 126. Lorsqu'il n'y a pas de panne le signal sortant du premier 112a ou du second 112b calculateur entre dans le second 112b ou premier 112a calculateur respectivement. En revanche, lorsqu'il a une panne, le signal sortant de l'une ou l'autre des calculateurs 112a, 112b n'arrive pas à destination. Ceci est traduit en langage signal par les équations suivantes :

$$S\_1\_2\_v = S\_1\_2 \text{ } \textit{when not} \text{ panne}$$

$$S\_2\_1\_v = S\_2\_1 \text{ } \textit{when not} \text{ panne.}$$

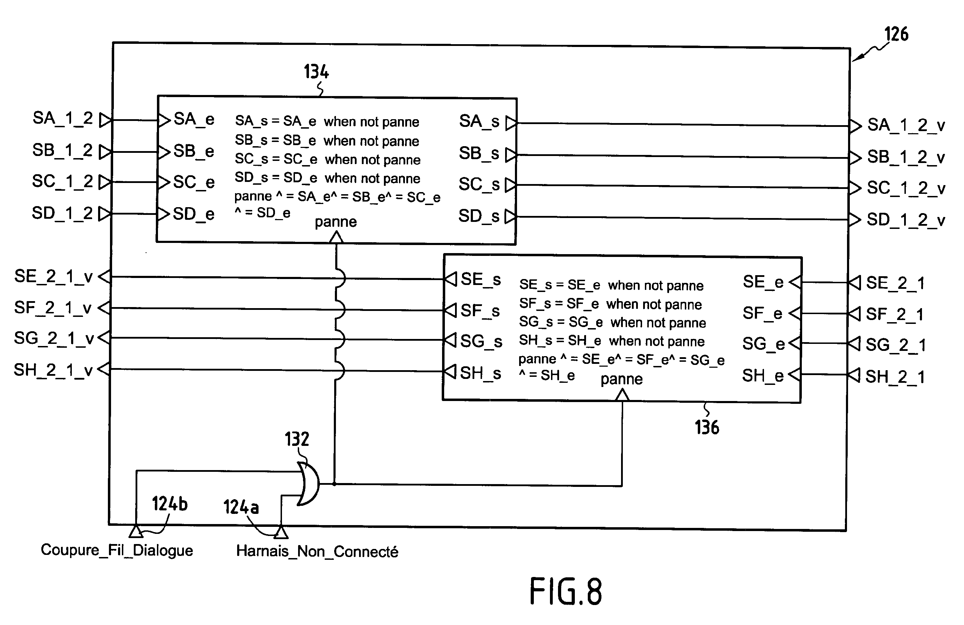

La figure 8 illustre très schématiquement le mécanisme d'injection de pannes et en particulier le moyen de mise en panne 126 de la figure 7. Ce moyen de mise en panne 126 comporte une première entrée de panne 124a correspondant à « harnais non connecté » et une seconde entrée de panne 124b correspondant à « coupure fil de dialogue ». Les première et seconde entrées de pannes 124a, 124b sont connectées aux entrées d'une porte logique « ou » 132 dont la sortie est relié à un premier moyen de liaison/coupure 134 permettant le transfert ou le non transfert des données depuis le premier calculateur 112a vers le second calculateur 112b et à un second moyen de liaison/coupure 136 permettant le transfert ou le non transfert des données depuis le second calculateur 112b vers le premier calculateur 112a.

Les entrées de pannes peuvent être assimilées à des boutons de mise en panne des composants modélisés. Ainsi, lors des simulations, il est possible d'introduire des pannes aux instants souhaités.

Lors de la mise en oeuvre de la recherche automatique par le moyen de preuve formelle d'une combinaison d'injection de pannes et/ou de valeurs d'entrées qui met en défaut la propriété déterminée, les entrées fixées à la valeur « faux » n'interviendront pas dans la recherche d'un scénario de contre-exemple. Seules les entrées libres entrent en jeu dans cette recherche.

Ainsi, lorsque aucune panne n'est injectée dans le premier moyen de liaison 134, les signaux d'entrées SA_e, SB_e, SC_e, et SD_e sont égaux respectivement aux signaux de sortie SA_s, SB_s, SC_s, et SD_s de ce moyen de liaison 134. Alors, les signaux SA_1_2, SB_1_2, SC_1_2, et SD_1_2 transmis depuis le premier calculateur 112a sont validé par le premier moyen de liaison 134 pour être envoyés, notés sous la forme SA_1_2_v, SB_1_2_v, SC_1_2_v, et SD_1_2_v respectivement, vers le second calculateur.

De même, lorsque aucune panne n'est injectée dans le second moyen de liaison 136, les signaux d'entrées SE_e, SF_e, SG_e, et SH_e sont égaux respectivement aux signaux de sortie SE_s, SF_s, SG_s, et SH_s, de ce moyen de liaison. Alors, les signaux SE_1_2, S_1_2, SG_1_2, et SH_1_2 transmis depuis le second calculateur 112b sont validé par le second moyen de liaison 136 pour être envoyés, sous la forme SE_1_2_v, SF_1 2_v, SG_1_2_v, et SH_1_2_v respectivement, vers le premier calculateur 112a.

Lorsque, la première entrée de panne 124a correspondant à « harnais non connecté » et/ou la seconde entrée de panne 124b correspondant à « coupure fil de dialogue » est libre, alors le moyen de preuve formelle ou prouveur peut introduire une coupure de harnais et/ou coupure de fil à tout moment. Dans ce cas, le ou les signaux transmis par l'un des calculateurs 112a, 112b n'arrivent pas à l'autre calculateur.

L'exemple ci-dessus, après une initialisation, peut être écrit en langage Signal de la façon suivante :

```
process xxx_process_sildex_1=
        ( ? boolean SA_e, panne, SB_e, SC_e, SD_e ;
         | boolean SA_s, SB_s, SC_s, SD_s ;)
    (|          (| SA_s = SA_e when not panne
                 | SB_s = SB_e when not panne
                 | SC_s = SC_e when not panne
                 | SD_s = SD_e when not panne
                 | panne^= SA_e^= SB_e^= SC_e^= SD_e
                 |)
    |) ;
process xxx_process_sildex_2=
        ( ? boolean SE_e, panne, SF_e, SG_e, SH_e ;
         | boolean SE_s, SF_s, SG_s, SH_s ;)
    (|          (| SE_s = SE_e when not panne
                 | SF_s = SF_e when not panne
                 | SG_s = SG_e when not panne
                 | SH_s = SH_e when not panne
                 | panne^= SE_e^= SF_e^= SG_e^= SH_e
                 |)
    |) ;
```

D'une manière générale, dans la modélisation d'un système physique comprenant deux calculateurs, on peut examiner les deux propriétés suivantes : « la modélisation du système ne peut pas se trouver avec deux calculateurs actifs » et « la modélisation du système ne peut pas se trouver avec deux calculateurs passifs ».

En outre, on peut envisager la modélisation de la situation d'une présence d'une panne simple dès la mise sous tension du système. Dans ce cas, on peut vérifier si toute panne simple présente lors de la mise en route, ne faisait pas évoluer le système vers les propriétés énoncées ci-dessus.

Par ailleurs, on peut envisager la modélisation de la présence d'une panne simple en fonctionnement, avec un démarrage simultané des deux calculateurs. Alors, on considère le cas ou chaque panne simple peut être introduite à tout instant. Pour cela on peut laisser l'entrée de la panne considérée libre, figeant toute les autres à faux.

Les pannes peuvent être choisies parmi un ensemble de pannes prédéfinies comportant les pannes suivantes : sans panne, échec de l'autotest, coupure, court-circuit, coupure à l'émission, harnais non connecté, panne de synchronisation, panne de NVM forcée à faux, panne de NVM forcée à vrai, panne du signal PPAVM forcée à faux, panne du signal PPAVM forcée à vrai, PPAVMTPB, mise en panne calculateur, panne du signal PH forcé à faux, panne du signal PH forcé à vrai, etc.

Ainsi, l'invention permet de contrôler la robustesse de la modélisation par rapport aux pannes, avant la réalisation du système physique permettant ainsi de réaliser un système ayant une sécurité optimale et de réduire le coût de développement de ce système.

Bien entendu, l'invention permet aussi de contrôler la robustesse d'un système physique déjà réalisé. Dans ce cas on modélise le système physique par un modèle en langage formel et on vérifie comme ci-dessus la robustesse de la modélisation du système physique selon des critères définis par des propriétés déterminées du système par rapport aux pannes.

## Revendications

1. Méthode de contrôle de la robustesse d'une modélisation d'un système électronique comportant un premier et un second calculateur (112a, 112b) pour contrôler un moteur d'avion, ladite méthode comporte les étapes suivantes :

   - définition d'un premier modèle (10) du système électronique modélisant ledit premier et second calculateur (112a, 112b) et un harnais (112c) intercalculateur comportant des fils de liaison permettant l'échange de données entre ledit premier et second calculateur (112a, 112b), ledit premier modèle (10) comportant un ensemble (12) de composants (12a, 12b, 12c) et au moins une interface d'entrée (14) destinée à l'introduction de valeurs d'entrées, ledit premier modèle étant défini dans un langage formel décrivant le comportement et la fonction de chacun desdits composants ;
   - définition dans le langage formel d'une propriété déterminée qui doit être satisfaite par la modélisation du système électronique ;
   - recherche automatique par un moyen de preuve formelle d'une combinaison de valeurs d'entrées qui met en défaut ladite propriété déterminée vis-à-vis du premier modèle pour vérifier la véracité de ladite propriété déterminée;
   - définition dans le langage formel d'un second modèle (20) correspondant au premier modèle enrichi par un mécanisme d'injection de pannes (22) lorsque ladite propriété déterminée est vérifiée comme étant vraie pour le premier modèle;
   - recherche automatique par un moyen de preuve formelle d'une combinaison d'injection de pannes et/ou de valeurs d'entrées qui met en défaut ladite propriété déterminée vis-à-vis du second modèle, ladite propriété déterminée étant considérée comme vraie par rapport au second modèle (20) lorsque le moyen de preuve formelle ne trouve aucune combinaison d'injection de pannes et/ou de valeurs d'entrées qui met en défaut ladite propriété déterminée; et
   - considérer la modélisation du système électronique comme robuste par rapport aux pannes vis-à-vis de ladite propriété déterminée lorsque ladite propriété déterminée est vérifiée comme étant vraie pour le second modèle.

2. Méthode selon la revendication 1, **caractérisée en ce que** le mécanisme d'injection de pannes (22) comporte l'injection d'au moins une panne dans le second modèle (20) à travers une interface d'entrée de pannes (24).

3. Méthode selon la revendication 2, **caractérisée en ce que** ledit au moins une panne est choisie parmi un ensemble de pannes prédéfinies comportant les pannes suivantes : sans panne, échec d'un autotest, coupure, court-circuit, coupure à l'émission, harnais non connecté, panne de synchronisation, panne de NVM forcée à faux, panne de NVM forcée à vrai, panne du signal PPAVM forcée à faux, panne du signal PPAVM forcée à vrai, PPAVMTPB, mise en panne calculateur, panne du signal PH forcé à faux, et panne du signal PH forcé à vrai.

4. Méthode selon l'une quelconque des revendications 1 à 3, **caractérisée en ce que** le mécanisme d'injection de pannes (22) comporte un moyen de mise en panne (126) correspondant à un moyen de coupure simulant une panne simple d'un fil de liaison coupé ou des fils en court-circuit ou que le harnais (112c) est non connecté.

5. Méthode selon l'une quelconque des revendications 1 à 4, **caractérisée en ce que** le mécanisme d'injection de pannes (22) comporte en outre la description dans le langage formel du ou des effets de ladite au moins une panne sur la fonction ou le comportement de chacun des composants dudit système électronique.

6. Méthode selon la revendication 1, **caractérisée en ce que** ladite combinaison d'injection de pannes et/ou de valeurs d'entrées mettant en défaut la propriété déterminée correspond à un scénario permettant de corriger la modélisation du système électronique pour le rendre plus robuste.

7. Méthode selon l'une quelconque des revendications 1 à 5 **caractérisée en ce que** la propriété déterminée exprime un état ou un comportement dudit système électronique.

8. Méthode selon la revendication 6 **caractérisée en ce que** la propriété déterminée est une propriété de sûreté dudit système électronique.

9. Méthode selon la revendication 7 ou 8, **caractérisée en ce que** la propriété déterminée est choisie parmi un ensemble de propriétés comportant : « la modélisation du système ne peut pas se trouver avec deux calculateurs actifs » et « la modélisation du système ne peut pas se trouver avec deux calculateurs passifs ».

10. Système de contrôle de la robustesse d'une modélisation d'un système électronique comportant un premier et un second calculateur (112a. 112b) pour contrôler un moteur d'avion, ledit système comprend :

   - un premier modèle (10) définissant le système électronique modélisant ledit premier et second calculateur (112a, 112b) et un harnais (112c) intercalculateur comportant des fils de liaison permettant l'échange de données entre ledit premier et second calculateur (112a, 112b), ledit premier modèle (10) comportant un ensemble (12) de composants (12a, 12b, 12c) et au moins une interface d'entrée (14) destinée à l'introduction de valeurs d'entrées, ledit premier modèle étant défini dans un langage formel décrivant le comportement et la fonction de chacun desdits composants ;
   - une propriété déterminée définie dans le langage formel et devant être satisfaite par la modélisation du système électronique ;
   - un moyen de preuve formelle pour rechercher automatiquement une combinaison de valeurs d'entrées qui met en défaut ladite propriété déterminée vis-à-vis du premier modèle pour vérifier la véracité de la dite propriété déterminée;
   - un second modèle (20) défini dans le langage formel, le second modèle correspondant au premier modèle enrichi par un mécanisme d'injection de pannes (22), le second modèle étant défini lorsque ladite propriété déterminée est vérifiée comme étant vraie pour le premier modèle ; et
   - un moyen de preuve formelle pour rechercher automatiquement une combinaison d'injection de pannes et/ou de valeurs d'entrées qui met en défaut ladite propriété déterminée vis-à-vis du second modèle, ladite propriété déterminée étant considérée comme vraie par rapport au second modèle (20) lorsque le moyen de preuve formelle ne trouve aucune combinaison d'injection de pannes et/ou de valeurs d'entrées qui met en défaut ladite propriété déterminée et la modélisation du système électronique étant considérée comme robuste par rapport aux pannes vis-à-vis de ladite propriété déterminée lorsque ladite propriété déterminée est vérifiée comme étant vraie pour le second modèle.

11. Système selon la revendication 10, **caractérisé en ce que** le mécanisme d'injection de pannes (22) comporte une interface d'entrée de pannes (24) et un moyen de mise en panne (26).

**Patentansprüche**

1. Verfahren zur Prüfung der Robustheit einer Modellierung eines elektronischen Systems, das einen ersten und einen zweiten Rechner (112a, 112b) zur Kontrolle eines Flugzeugtriebwerks umfasst, das Verfahren umfasst die folgenden Schritte:

   - Definieren eines ersten Modells (10) des elektronischen Systems, das den ersten und zweiten Rechner (112a, 112b) und einen Zwischenrechner-Kabelbaum (112c), welcher Verbindungsleitungen umfasst, die den Datenaustausch zwischen dem ersten und dem zweiten Rechner (112a, 112b) ermöglichen, modelliert, wobei das erste Modell (10) eine Anordnung (12) von Komponenten (12a, 12b, 12c) und wenigstens eine Eingabeschnittstelle (14), die zur Eingabe von Eingangswerten bestimmt ist, umfasst, wobei das erste Modell in einer formalen Sprache definiert ist, die das Verhalten und die Funktion einer jeden der Komponenten beschreibt,

- Definieren einer bestimmten Eigenschaft, die durch die Modellierung des elektronischen Systems erfüllt werden muss, in der formalen Sprache,

- automatisches Suchen, durch ein Formalbeweismittel, einer Kombination von Eingangswerten, die die bestimmte Eigenschaft gegenüber dem ersten Modell als unzulänglich herausstellt, um die Richtigkeit der bestimmten Eigenschaft zu überprüfen,

- Definieren, in der formalen Sprache, eines zweiten Modells (20), das dem ersten Modell, erweitert durch einen Mechanismus zum Einspeisen von Störungen (22), entspricht, wenn die bestimmte Eigenschaft für das erste Modell als wahr bestätigt wird,

- automatisches Suchen, durch ein Formalbeweismittel, einer Kombination einer Einspeisung von Störungen und/oder von Eingangswerten, die die bestimmte Eigenschaft gegenüber dem zweiten Modell als unzulänglich herausstellt, wobei die bestimmte Eigenschaft gegenüber dem zweiten Modell (20) als wahr betrachtet wird, wenn das Formalbeweismittel keine Kombination einer Einspeisung von Störungen und/oder von Eingangswerten, die die bestimmte Eigenschaft als unzulänglich herausstellt, findet, und

- Betrachten der Modellierung des elektronischen Systems als störungsrobust gegenüber der bestimmten Eigenschaft, wenn die bestimmte Eigenschaft für das zweite Modell als wahr bestätigt wird.

2. Verfahren nach Anspruch 1, **dadurch gekennzeichnet, dass** der Störungseinspeisungsmechanismus (22) das Einspeisen wenigstens einer Störung in das zweite Modell (20) durch eine Störungseingabeschnittstelle (24) umfasst.

3. Verfahren nach Anspruch 2, **dadurch gekennzeichnet, dass** die wenigstens eine Störung aus einer Menge von vordefinierten Störungen ausgewählt ist, welche die folgenden Störungen umfasst: störungsfrei, Nichtbestehen eines Selbsttests, Unterbrechung, Kurzschluss, Sendeunterbrechung, Kabelbaum nicht angeschlossen, Synchronisationsstörung, forcierte NVM-Störung auf falsch, forcierte NVM-Störung auf wahr, forcierte Störung des PPAVM-Signals auf falsch, forcierte Störung des PPAVM-Signals auf wahr, PPAVMTPB, Simulieren Rechnerstörung, forcierte Störung des PH-Signals auf falsch und forcierte Störung des PH-Signals auf wahr.

4. Verfahren nach einem der Ansprüche 1 bis 3, **dadurch gekennzeichnet, dass** der Störungseinspeisungsmechanismus (22) ein Störungssimulationsmittel (126) umfasst, das einem Unterbrechungsmittel entspricht, welches eine einfache Störung einer getrennten Verbindungsleitung oder kurzgeschlossene Leitungen simuliert oder simuliert, dass der Kabelbaum (112c) nicht angeschlossen ist.

5. Verfahren nach einem der Ansprüche 1 bis 4, **dadurch gekennzeichnet, dass** der Störungseinspeisungsmechanismus (22) ferner die Beschreibung, in der formalen Sprache, der Wirkung oder Wirkungen der wenigstens einen Störung auf die Funktion oder das Verhalten einer jeden der Komponenten des elektronischen Systems umfasst.

6. Verfahren nach Anspruch 1, **dadurch gekennzeichnet, dass** die Kombination einer Einspeisung von Störungen und/oder von Eingangswerten, die die bestimmte Eigenschaft als unzulänglich herausstellt, einem Szenario entspricht, das ermöglicht, die Modellierung des elektronischen Systems zu korrigieren, um es robuster zu machen.

7. Verfahren nach einem der Ansprüche 1 bis 5, **dadurch gekennzeichnet, dass** die bestimmte Eigenschaft einen Zustand oder ein Verhalten des elektronischen Systems zum Ausdruck bringt.

8. Verfahren nach Anspruch 6, **dadurch gekennzeichnet, dass** die bestimmte Eigenschaft eine Sicherheitseigenschaft des elektronischen Systems ist.

9. Verfahren nach Anspruch 7 oder 8, **dadurch gekennzeichnet, dass** die bestimmte Eigenschaft aus einer Menge von Eigenschaften, umfassend "die Modellierung des Systems kann sich nicht mit zwei aktiven Rechnern ereignen" und "die Modellierung des Systems kann sich nicht mit zwei passiven Rechnern ereignen", ausgewählt ist.

10. System zur Prüfung der Robustheit einer Modellierung eines elektronischen Systems, das einen ersten und einen zweiten Rechner (112a, 112b) zur Kontrolle eines Flugzeugtriebwerks umfasst, das System umfasst:

- ein das elektronische System definierendes erstes Modell (10), das den ersten und zweiten Rechner (112a, 112b) und einen Zwischenrechner-Kabelbaum (112c), welcher Verbindungsleitungen umfasst, die den Datenaustausch zwischen dem ersten und dem zweiten Rechner (112a, 112b) ermöglichen, modelliert, wobei das erste Modell (10) eine Anordnung (12) von Komponenten (12a, 12b, 12c) und wenigstens eine Eingabeschnittstelle (14), die zur Eingabe von Eingangswerten bestimmt ist, umfasst, wobei das erste Modell in einer formalen Sprache definiert ist, die das Verhalten und die Funktion einer jeden der Komponenten beschreibt,

- eine bestimmte Eigenschaft, die in der formalen Sprache definiert ist und die durch die Modellierung des elektronischen Systems erfüllt werden muss,

- ein Formalbeweismittel zum automatischen Suchen einer Kombination von Eingangswerten, die die bestimmte Eigenschaft gegenüber dem ersten Modell als unzulänglich herausstellt, um die Richtigkeit der bestimmten Eigenschaft zu überprüfen,

- ein in der formalen Sprache definiertes zweites Modell (20), wobei das zweite Modell dem ersten Modell, erweitert durch einen Mechanismus zum Einspeisen von Störungen (22), entspricht, wobei das zweite Modell definiert wird, wenn die bestimmte Eigenschaft für das erste Modell als wahr bestätigt wird, und

- ein Formalbeweismittel zum automatischen Suchen einer Kombination einer Einspeisung von Störungen und/oder von Eingangswerten, die die bestimmte Eigenschaft gegenüber dem zweiten Modell als unzulänglich herausstellt, wobei die bestimmte Eigenschaft gegenüber dem zweiten Modell (20) als wahr betrachtet wird, wenn das Formalbeweismittel keine Kombination einer Einspeisung von Störungen und/oder von Eingangswerten, die die bestimmte Eigenschaft als unzulänglich herausstellt, findet, und wobei die Modellierung des elektronischen Systems als störungsrobust gegenüber der bestimmten Eigenschaft betrachtet wird, wenn die bestimmte Eigenschaft für das zweite Modell als wahr bestätigt wird.

**11.** System nach Anspruch 10, **dadurch gekennzeichnet, dass** der Störungseinspeisungsmechanismus (22) eine Störungseingabeschnittstelle (24) und ein Störungssimulationsmittel (26) umfasst.

**Claims**

**1.** A method of verifying the robustness of a model of an electronic system comprising a first and a second computer (112a, 112b) for controlling an aircraft engine, the method comprising the following steps:

. defining a first model (10) of the electronic system modeling said first and said second computer (112a, 112b) and an inter-computer back gear (112c) comprising contact wires for data exchanging between said first and said second computer (112a, 112b), said first model (10) comprising a set (12) of components (12a, 12b, 12c) and at least an input interface (14) for the introduction of input values, said first model being defined in a formal language describing the behavior and the function of each of said components;

. defining in the formal language a determined property that must be satisfied by modeling the electronic system;

. searching automatically using a formal proof means of a combination of input values that puts at fault said determined property vis-à-vis the first model for verifying the truth of said determined property;

defining in the formal language a second model (20) corresponding to the first model enriched by a fault injection mechanism (22) when said determined property is verified as being true for the first model; and

. searching automatically using a formal proof means of a combination of fault injection and / or input values that puts at fault said determined property vis-à-vis the second model, said determined property being considered as being true relative to the second model (20) when the formal proof means finds no combination of fault injection and / or input values that puts at fault said determined property and considering the modeling of the electronic system to be robust with respect to faults vis-à-vis said determined property when said determined property is verified as being true for the second model.

**2.** Method according to claim 1, **characterized in that** the fault injection mechanism (22) comprises injecting at least one fault in the second model (20) through a fault input interface (24).

**3.** Method according to claim 2, **characterized in that** said at least one fault is selected from a set of predefined faults comprising the following faults: without fault, auto test failure, cut, short-circuit, cut when emitting, back gear not connected, fault of synchronization, NVM fault due a false forcing, NVM fault due a true forcing, PPAVM signal fault due a false forcing, PPAVM signal fault due a true forcing, PPAVMTPB, computer fault applier, PH signal fault due a false forcing, PH signal fault due a true forcing.

**4.** Method according to any one of claims 1 to 3, **characterized in that** the fault injection mechanism (22) comprises a fault applier means (126) corresponding to a cutting means simulating a simple fault of a cut wire or wires in short-circuit or the back gear not connected.

**5.** Method according to any one of claims 1 to 4, **characterized in that** the fault injection mechanism (22) further comprises the description in the formal language of effect(s) of said at least one fault on the function or the behavior of each of said components of said electronic system.

6. Method according to claim 1, **characterized in that** said combination of fault injection and / or input values putting at fault the determined property corresponds to a scenario for correcting the model of the electronic system to make it more robust.

7. Method according to any one of claims 1 to 5, **characterized in that** the determined property expresses a state or a behavior of said electronic system.

8. Method according to claim 6, **characterized in that** the determined property is a safety property of said electronic system.

9. Method according to claim 7 or 8, **characterized in that** the determined property is selected from a set a properties comprises: "the modeling of the system cannot be found with two active computers" and "the modeling of the system cannot be found with two passive computers".

10. A system of verifying the robustness of a model of an electronic system comprising a first and a second computer (112a, 112b) for controlling an aircraft engine, the system comprising:

   . a first model (10) defining the electronic system modeling said first and said second computer (112a, 112b) and an inter-computer back gear (112c) comprising contact wires for data exchanging between said first and said second computer (112a, 112b), said first model (10) comprising a set (12) of components (12a, 12b, 12c) and at least an input interface (14) for the introduction of input values, said first model being defined in a formal language describing the behavior and the function of each of said components;
   . a determined property defined in the formal language and that must be satisfied by modeling the electronic system;
   . a formal proof means for automatically searching a combination of input values that puts at fault said determined property vis-à-vis the first model for verifying the truth of said determined property;
   a second model (20) defined in the formal language, the second model corresponding to the first model enriched by a fault injection mechanism (22), the second model being defined when said determined property is verified as being true for the first model; and
   . a formal proof means for automatically searching a combination of fault injection and / or input values that puts at fault said determined property vis-à-vis the second model, said determined property being considered as being true relative to the second model (20) when the formal proof means finds no combination of fault injection and / or input values that puts at fault said determined property and the modeling of the electronic system being considered to be robust with respect to faults vis-à-vis said determined property when said determined property is verified as being true for the second model.

11. The system of claim 10, **characterized in that** the fault injection mechanism (22) comprises a fault input interface (24) and a fault applier means (26).

FIG.1

FIG.2

FIG.4

DEFINITION DU PREMIER MODELE DANS UN LANGAGE FORMEL — E1

DEFINITION D'UNE PROPRIETE DETERMINEE — E2

TEST DE VERITE DE LA PROPRIETE ? — E3

NON

OUI

FOURNIR UN DIAGNOSTIC — E5

PREMIER MODELE EST VALIDE — E4

ANALYSE DU DIAGNOSTIC — E6

FIG.3

DEFINITION DU SECOND
MODELE
CORRESPONDANT AU
PREMIER
MODELE AVEC UN
MECANISME
D'INJECTION DE PANNES ～ E11

TEST DE
VERITE DE LA
PROPRIETE DEFINIE
A L'ETAPE E2
?  E13

NON   OUI

FOURNIR UN
DIAGNOSTIC ～ E15

LA MODELISATION
DU SYSTEME
EST ROBUSTE
PAR RAPPORT
AUX PANNES

E14

ANALYSE DU
DIAGNOSTIC ～ E16

FIG.5

FIG.6

FIG.7

EP 1 593 982 B1

**134**

| | |
|---|---|
| SA_1_2 ▷ | ▷ SA_e |
| SB_1_2 ▷ | ▷ SB_e |
| SC_1_2 ▷ | ▷ SC_e |
| SD_1_2 ▷ | ▷ SD_e |

SA_s = SA_e  when not panne
SB_s = SB_e  when not panne
SC_s = SC_e  when not panne
SD_s = SD_e  when not panne
panne ^ = SA_e^ = SB_e^ = SC_e
^ = SD_e

SA_s ▷ → SA_1_2_v
SB_s ▷ → SB_1_2_v
SC_s ▷ → SC_1_2_v
SD_s ▷ → SD_1_2_v

panne

SE_2_1_v ◁ ◁ SE_s
SF_2_1_v ◁ ◁ SF_s
SG_2_1_v ◁ ◁ SG_s
SH_2_1_v ◁ ◁ SH_s

SE_s = SE_e  when not panne
SF_s = SF_e  when not panne
SG_s = SG_e  when not panne
SH_s = SH_e  when not panne
panne ^ = SE_e^ = SF_e^ = SG_e
^ = SH_e

SE_e ◁ ◁ SE_2_1
SF_e ◁ ◁ SF_2_1
SG_e ◁ ◁ SG_2_1
SH_e ◁ ◁ SH_2_1

panne

**136**

**132**

**124b**  **124a**

Coupure_Fil_Dialogue    Harnais_Non_Connecté

**126**

FIG.8

## RÉFÉRENCES CITÉES DANS LA DESCRIPTION

**Littérature non-brevet citée dans la description**

- **CHAKRABARTY et al.** A virtual test-bench for analog circuit testability analysis and fault. *AUTOTEST-CON 98, IEEE Systems Readiness Technology Conference,* 1998